# EUROPEAN PATENT APPLICATION

(11) **EP 4 644 043 A1**
(43) Date of publication of application: **05.11.2025**
(21) Application number: 23911415.0
(22) Date of filing: 14.11.2023
(51) Int. Cl.: B24B 37/013, B24B 49/04, B24B 49/10, B24B 49/12, B24B 49/14, H01L 21/304

(54) **POLISHING METHOD, POLISHING DEVICE, AND COMPUTER-READABLE RECORDING MEDIUM**

(30) Priority: 26.12.2022 JP 2022208734
(71) Applicant: EBARA CORPORATION, Ota-ku, Tokyo 144-8510 (JP)
(72) Inventor: SATORI, Hirotaka, Tokyo 144-8510 (JP)
(74) Representative: Pritzlaff, Stefanie Lydia
(86) International application number: PCT/JP2023/040890
(87) International publication number: WO 2024/142632

(57) **Abstract**

The present invention relates to a polishing method of polishing a substrate, such as a wafer or a panel. The polishing method includes: rotating a polishing pad (polishing tool) (1) having a polishing surface (1a); pressing a substrate (W) against the polishing surface (1a) to polish the substrate (W); during polishing of the substrate, determining whether each of multiple measurement data points measured by a sensor (30) is an effective data point; and determining a representative measurement value of physical quantity based on a measurement value of a measurement data point that has been determined to be the effective data point each time the polishing table (3) makes one revolution. Determining whether each of the multiple measurement data points is the effective data point comprises counting the number of measurement data points within a search area and determining that a determination-target measurement data point is the effective data point when the number of measurement data points within the search area is equal to or more than a threshold value.

## Description

### Technical Field

The present invention relates to a polishing method and a polishing apparatus for polishing a substrate, such as a wafer or a panel, and relates to a computer-readable storage medium storing a program for determining physical quantity of the substrate being polished.

### Background Art

Manufacturing processes of semiconductor devices include various processes, such as a process of polishing a dielectric film (e.g., SiO₂) and a process of polishing a metal film (e.g., copper or tungsten). Manufacturing processes of backside illumination CMOS sensor and through-silicon via (TSV) include a process of polishing a silicon layer (or a silicon wafer), in addition to the polishing processes of the dielectric film and the metal film.

Polishing of a substrate, such as a wafer or a panel, is generally performed using a chemical-mechanical-polishing apparatus (CMP apparatus). This CMP apparatus is configured to polish a surface of the substrate by sliding contact of the substrate and a polishing pad while supplying a slurry onto the polishing pad attached to a polishing table. Polishing of the substrate is terminated when a thickness of a film (e.g., the dielectric film, the metal film, or the silicon layer), constituting the surface of the substrate, has reached a predetermined target value. Therefore, the film thickness of the substrate is measured during the polishing of the substrate. Furthermore, physical quantity, such as temperature, sound, or vibration of the substrate, which indicates a polishing state, may be measured to monitor the polishing state during the polishing of the substrate.

A sensor for measuring physical quantity, such as the film thickness of the substrate, is installed in the polishing table and is rotated together with the polishing table. During polishing of the substrate, the physical quantity is measured at multiple measurement points on the substrate when the sensor is located in a predetermined measurement region each time the polishing table makes one revolution.

### Citation List

### Patent Literature

Patent document 1: Japanese laid-open patent publication No. 2010-253627

### Summary of Invention

### Technical Problem

In the CMP process, the polishing head and the substrate may be oscillated during polishing of the substrate while the substrate is pressed against the polishing pad on the rotating polishing table by the polishing head. In such a case, a position of the substrate with respect to the sensor varies each time the polishing table revolves, so that the sensor may be located outside the substrate in the predetermined measurement region. Therefore, measurement data when the sensor is located outside the substrate may be noise. As a result, the physical quantity of the substrate may not be accurately measured.

Thus, the present invention provides a polishing method and a polishing apparatus capable of accurately measuring physical quantity of a substrate being polished, and a computer-readable storage medium storing a program for determining the physical quantity of the substrate being polished.

### Solution to Problem

In an embodiment, there is provided a polishing method comprising: rotating a polishing table supporting a polishing tool having a polishing surface; pressing a substrate against the polishing surface by a polishing head to polish the substrate; during polishing of the substrate, measuring physical quantity at multiple measurement points by a sensor installed in the polishing table; determining whether each of multiple measurement data points is an effective data point, the multiple measurement data points being indicative of measurement values of the physical quantity and measuring times at the multiple measurement points measured during one revolution of the polishing table; and determining a representative measurement value of the physical quantity based on a measurement value of a measurement data point that has been determined to be the effective data point each time the polishing table makes one revolution, wherein determining whether each of the multiple measurement data points is the effective data point comprises counting the number of measurement data points within a search area and determining that a determination-target measurement data point is the effective data point when the number of measurement data points within the search area is equal to or more than a threshold value, and the search area is defined by a measurement-value range and a time range, the measurement-value range has a predetermined width including a measurement value of the determination-target measurement data point, and the time range has a predetermined width including a measuring time of the determination-target measurement data point.

In an embodiment, the determination-target measurement data point is the latest measurement data point among the measurement data points within the search area.

In an embodiment, the effective data point comprises multiple effective data points, and determining the representative measurement value comprises calculating an average value of the multiple effective data points.

In an embodiment, the polishing method further comprises terminating polishing of the substrate when the representative measurement value reaches a target value.

In an embodiment, polishing the substrate comprises pressing the substrate against the polishing surface by the polishing head to polish the substrate while the polishing head is oscillated by a polishing-head oscillating mechanism.

In an embodiment, the substrate comprises a quadrilateral substrate.

In an embodiment, the physical quantity comprises any one of film thickness, temperature, sound, and vibration.

In an embodiment, there is provided a polishing apparatus comprising: a polishing table configured to support a polishing tool having a polishing surface; a table motor configured to rotate the polishing table; a polishing head configured to press the substrate against the polishing surface; a sensor configured to measure physical quantity; and a processing system configured to determine whether each of multiple measurement data points is an effective data point during polishing of the substrate and determine a representative measurement value of the physical quantity based on a measurement value of a measurement data point that has been determined to be the effective data point each time the polishing table makes one revolution, the multiple measurement data points being indicative of measurement values of the physical quantity and measuring times at multiple measurement points measured during one revolution of the polishing table, wherein the processing system is configured to count the number of measurement data points within a search area and is configured to determine that a determination-target measurement data point is the effective data point when the number of measurement data points within the search area is equal to or more than a threshold value, and the search area is defined by a measurement-value range and a time range, the measurement-value range has a predetermined width including a measurement value of the determination-target measurement data point, and the time range has a predetermined width including a measuring time of the determination-target measurement data point.

In an embodiment, the determination-target measurement data point is the latest measurement data point among the measurement data points within the search area.

In an embodiment, the effective data point comprises multiple effective data points, and the processing system is configured to calculate an average value of the multiple effective data points to determine the representative measurement value.

In an embodiment, the processing system is configured to terminate polishing of the substrate when the representative measurement value reaches a target value.

In an embodiment, the polishing apparatus further comprises a polishing-head oscillating mechanism configured to oscillate the polishing head.

In an embodiment, the substrate comprises a quadrilateral substrate.

In an embodiment, the sensor comprises any one of a film-thickness sensor, a temperature sensor, an acoustic sensor, and a vibration sensor.

In an embodiment, there is provided a computer-readable storage medium storing a program for causing a computer to perform: during polishing of a substrate, determining whether each of multiple measurement data points is an effective data point, the multiple measurement data points being indicative of measurement values of physical quantity and measuring times at the multiple measurement points measured by a sensor during one revolution of a polishing table, the sensor being installed in the polishing table supporting a polishing tool having a polishing tool; and determining a representative measurement value of the physical quantity based on a measurement data point that has been determined to be the effective data point each time the polishing table makes one revolution, wherein determining whether each of the multiple measurement data points is the effective data point is performed by counting the number of measurement data points within a search area and determining that a determination-target measurement data point is the effective data point when the number of measurement data points within the search area is equal to or more than a threshold value, and the search area is defined by a measurement-value range and a time range, the measurement-value range has a predetermined width including a measurement value of the determination-target measurement data point, and the time range has a predetermined width including a measuring time of the determination-target measurement data point.

In an embodiment, the effective data point comprises multiple effective data points, and determining the representative measurement value comprises calculating an average value of the multiple effective data points.

In an embodiment, the program is configured to cause the computer to further perform terminating polishing of the substrate when the representative measurement value reaches a target value.

### Advantageous Effects of Invention

According to the present invention, whether each of the multiple measurement data points is the effective data point is determined. These multiple measurement data points are indicative of measurement values of the physical quantity and the measuring times at the multiple measurement points measured by the sensor. Furthermore, the representative measurement value of the physical quantity is determined based on the measurement value of the measurement data point that has been determined to be the effective data point each time the polishing table makes one revolution. As a result, the physical quantity of the substrate being polished can be accurately measured.

### Brief Description of Drawings

[FIG. 1] FIG. 1 is a schematic diagram showing an embodiment of a polishing apparatus; [FIG. 2] FIG. 2 is a schematic diagram showing an example of multiple measurement points in a measurement region;
[FIG. 3] FIG. 3 is a graph showing an example of measurement data of physical quantity at the multiple measurement points measured by a sensor;
[FIG. 4A] FIG. 4A is a diagram illustrating a method of determining an effective data point;
[FIG. 4B] FIG. 4B is a diagram illustrating the method of determining the effective data point; and
[FIG. 5] FIG. 5 is a diagram showing effective data points determined by a processing system.

### Description of Embodiments

Embodiments of the present invention will now be described with reference to the drawings.

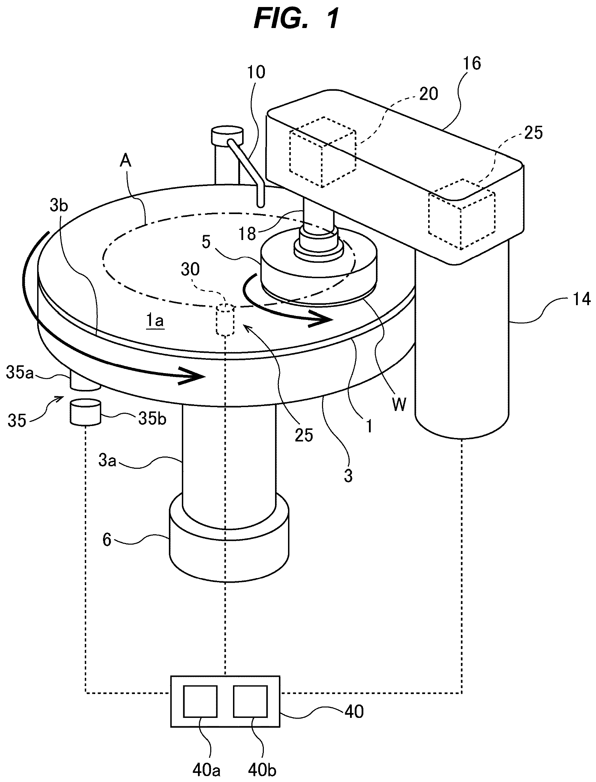

FIG. 1 is a schematic diagram showing an embodiment of a polishing apparatus. The polishing apparatus is configured to chemically and mechanically polish a substrate W, such as a wafer or a panel. As shown in FIG. 1, the polishing apparatus includes a polishing table 3 configured to support a polishing pad 1 as a polishing tool, a polishing head 5 configured to press the substrate W against a polishing surface 1a, and a polishing-liquid supply nozzle 10 configured to supply a polishing liquid (e.g., a slurry) onto the polishing pad 1. The polishing pad 1 has the polishing surface 1a. In one embodiment, a fixed abrasive having a polishing surface may be used as the polishing tool.

The polishing apparatus further includes a support shaft 14, a polishing-head arm 16 coupled to an upper end of the support shaft 14, a polishing-head shaft 18 rotatably supported by a free end of the polishing-head arm 16, a polishing-head rotating mechanism 20 configured to rotate the polishing head 5 together with the polishing-head shaft 18, and a polishing-head oscillating mechanism 25 configured to oscillate the polishing head 5. The polishing head 5 is fixed to a lower end of the polishing-head shaft 18. The polishing head 5 is configured to be able to hold the substrate W on its lower surface. The substrate W is held such that a surface to be polished faces downward. In this embodiment, the substrate W and the polishing head 5 have a circular shape, while in one embodiment, the substrate W may be a quadrilateral substrate, and the polishing head 5 may have a quadrilateral shape.

The polishing-head rotating mechanism 20 is disposed in the polishing-head arm 16. The polishing-head rotating mechanism 20 is coupled to the polishing-head shaft 18 and is configured to rotate the polishing-head shaft 18 and the polishing head 5 in a direction indicated by an arrow. The polishing-head rotating mechanism 20 is constituted of, for example, a combination of a motor, timing pulleys, and a belt. In FIG. 1, the polishing-head rotating mechanism 20 is schematically depicted.

The polishing-head oscillating mechanism 25 is disposed in the polishing-head arm 16. The polishing-head arm 16 is configured to be rotated about the support shaft 14 by the polishing-head oscillating mechanism 25. The polishing head 5 can be oscillated over the polishing table 3 along the polishing surface 1a by the oscillation of the polishing-head arm 16. The polishing-head oscillating mechanism 25 is constituted of, for example, a combination of a motor and gears. In FIG. 1, the polishing-head oscillating mechanism 25 is schematically depicted. In one embodiment, the polishing-head oscillating mechanism 25 may be installed in the support shaft 14.

The polishing-head shaft 18 is coupled to a not-shown polishing-head elevating mechanism (including a ball-screw mechanism, etc.). This polishing-head elevating mechanism is configured to vertically move the polishing-head shaft 18 relative to the polishing-head arm 16. The vertical movement of the polishing-head shaft 18 causes the polishing head 5 to move vertically relative to the polishing-head arm 16 and the polishing table 3.

The polishing apparatus further includes a table motor 6 configured to rotate the polishing table 3. The table motor 6 is arranged below the polishing table 3, and the polishing table 3 is coupled to the table motor 6 via a table shaft 3a. The table motor 6 is configured to rotate the polishing table 3 and the polishing pad 1 about the table shaft 3a in a direction indicated by an arrow.

The polishing apparatus further includes a processing system 40 configured to control operations of the polishing apparatus. The table motor 6, the polishing-liquid supply nozzle 10, the polishing-head rotating mechanism 20, and the polishing-head oscillating mechanism 25 are electrically coupled to the processing system 40, and operations of the table motor 6, the polishing-liquid supply nozzle 10, the polishing-head rotating mechanism 20, and the polishing-head oscillating mechanism 25 are controlled by the processing system 40.

The processing system 40 is composed of at least one computer. The processing system 40 includes a memory 40a storing programs therein for controlling the operations of the polishing apparatus, and an arithmetic device 40b configured to perform arithmetic operations according to instructions contained in the programs. The memory 40a includes a main memory, such as a random-access memory (RAM), and an auxiliary memory, such as a hard disk drive (HDD) or a solid state drive (SSD). Examples of the arithmetic device 40b include a CPU (central processing unit) and a GPU (graphic processing unit). However, the specific configuration of the processing system 40 is not limited to these examples.

Polishing of the substrate W is performed as follows. The polishing head 5 and the polishing table 3 are rotated in the directions indicated by the arrows, and the polishing head 5 is oscillated by the polishing-head oscillating mechanism 25. Furthermore, the polishing liquid (slurry) is supplied onto the polishing pad 1 from the polishing-liquid supply nozzle 10. The polishing head 5 then presses the substrate W against the polishing surface 1a of the polishing pad 1. A surface of the substrate W is polished by a combination of a chemical action of the polishing liquid and mechanical action(s) of abrasive grains contained in the polishing liquid and/or the polishing pad. In particular, when the substrate W is a quadrilateral substrate, the entire substrate W can be polished uniformly due to the oscillation of the polishing head 5 during polishing of the substrate W. In one embodiment, the substrate W may be polished with a position of the polishing head 5 fixed without oscillating the polishing head 5 by the polishing-head oscillating mechanism 25.

The polishing apparatus further includes a sensor 30 installed in the polishing table 3 and configured to measure physical quantity. The physical quantity to be measured is any one of film thickness, temperature, sound, and vibration, and the sensor 30 is any one of a film-thickness sensor, a temperature sensor, an acoustic sensor, and a vibration sensor. Examples of the film-thickness sensor include an optical sensor and an eddy-current sensor. The sensor 30 is rotated together with the polishing table 3 as indicated by a reference symbol A, and measures the physical quantity of the substrate W in a predetermined measurement region including the substrate W held by the polishing head 5.

In one embodiment, the film-thickness sensor is configured to measure a thickness of a film (e.g., a dielectric film, a metal film, or a silicon layer) constituting the surface of the substrate W. In one embodiment, the temperature sensor is configured to measure a surface temperature of the substrate W. In one embodiment, the acoustic sensor is configured to detect sound caused by polishing of the substrate W. In one embodiment, the vibration sensor is configured to detect vibration caused by polishing of the substrate W.

The polishing apparatus further includes a trigger sensor 35 configured to detect a rotation of the polishing table 3. The trigger sensor 35 includes a dog 35a attached to a circumferential edge of the polishing table 3 and a proximity sensor 35b disposed close to the dog 35a. The trigger sensor 35 generates a trigger signal indicating that the polishing table 30 makes one rotation based on a positional relationship between the dog 35a and the proximity sensor 35b. More specifically, when the dog 35a is closest to the proximity sensor 35b with the rotation of the polishing table 3, the proximity sensor 35b generates the trigger signal. The proximity sensor 35b is coupled to the processing system 40 and transmits the trigger signal to the processing system 40.

The trigger sensor 35 is a sensor for detecting a measuring start timing (and a measuring end timing) of the sensor 30. The sensor 30 starts (and stops) measuring of the physical quantity at a timing based on the trigger signal detected by the trigger sensor 35. In this way, the sensor 30 is configured to measure the physical quantity in the predetermined measurement region each time the polishing table 3 makes one revolution.

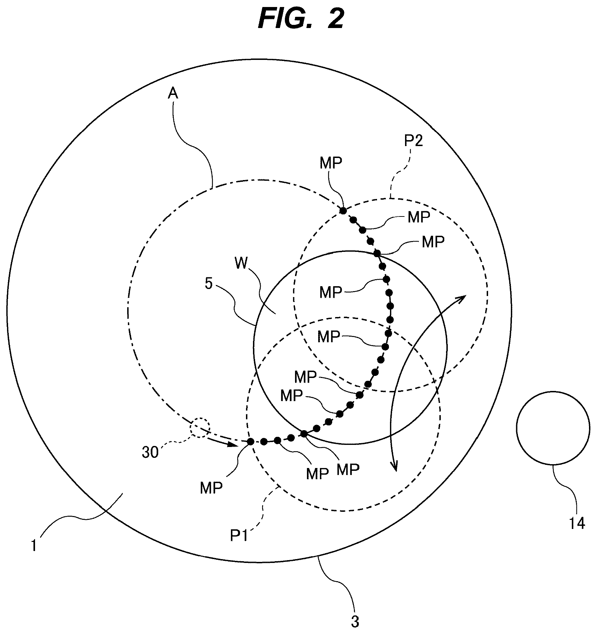

FIG. 2 is a schematic diagram showing an example of multiple measurement points MP in the measurement region. The sensor 30 measures the physical quantity at the multiple measurement points MP in the measurement region each time the polishing table 3 makes one revolution. The physical quantity at the multiple measurement points MP are measured by the sensor 30 at predetermined time intervals. In this embodiment, the polishing table 3 rotates at a constant speed, and the multiple measurement points MP are located at equal intervals on the path of the sensor 30.

During polishing of the substrate W, the polishing head 5 and the substrate W are oscillated around the support shaft 14 by the polishing-head oscillating mechanism 25 between a substrate position P1 and a substrate position P2 indicated by dotted lines in FIG. 2. In this embodiment, the measurement region is located on the path of the sensor 30 in a location between the substrate position P1 and the substrate position P2. The multiple measurement points MP are located at the equal intervals in the measurement region. The sensor 30 is coupled to the processing system 40. Measurement data of the physical quantity at the multiple measurement points MP measured by the sensor 30 are transmitted to the processing system 40.

Since the measurement region is larger than a region where the sensor 30 traverses the substrate W, a part of the multiple measurement points MP may not be located on the substrate W. Measurement data at measurement point(s) MP that is not located on the substrate W may be noise data for monitoring the physical quantity of the substrate W being polished. Thus, the processing system 40 selects effective measurement data that does not contain the noise data from the measurement data each time the polishing table 3 makes one revolution, and determines a representative measurement value of the physical quantity of the substrate W based on the effective measurement data.

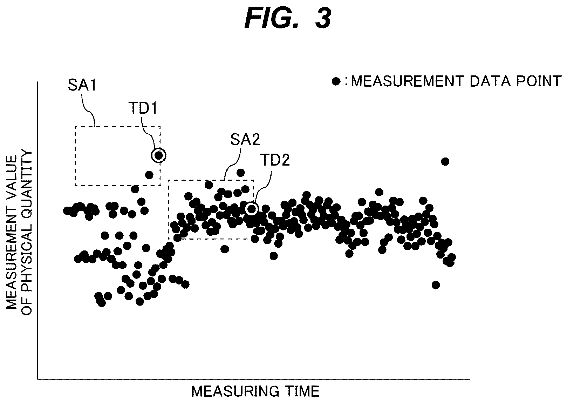

FIG. 3 is a graph showing an example of the measurement data of the physical quantity at the multiple measurement points MP measured by the sensor 30. In FIG. 3, a horizontal axis represents measuring time, and a vertical axis represents measurement value of the physical quantity. The measurement data is composed of multiple measurement data points (indicated by black dots) indicating measurement values of the physical quantity and measuring times at the multiple measurement points MP. Although the number of measurement data points shown in FIG. 3 is depicted differently from the number of measurement points MP shown in FIG. 2 described above, the number of measurement data points and the number of measurement points MP are the same.

The processing system 40 is configured to determine whether each of the multiple measurement data points is an effective data point. Specifically, the processing system 40 is configured to count the number of measurement data points within a search area for each of the multiple measurement data points, and is configured to determine that a determination-target measurement data point is the effective data point when the number of measurement data points within the search area is equal to or more than a threshold value.

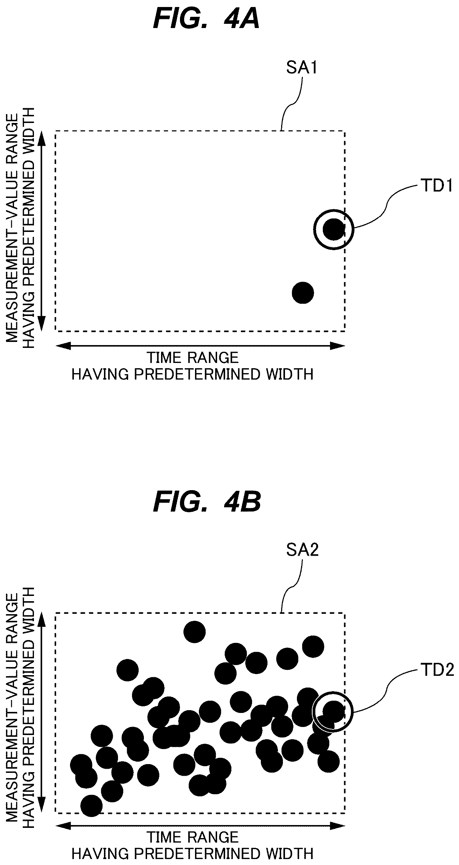

FIGS. 4A and 4B are diagrams illustrating a method of determining the effective data point. FIG. 4A shows a case of determining whether a determination-target measurement data point TD1 shown in FIG. 3 is the effective data point, and FIG. 4B shows a case of determining whether a determination-target measurement data point TD2 shown in FIG. 3 is the effective data point. In FIG. 4A, a search area for determining whether the determination-target measurement data point TD1 is the effective data point is represented by a reference symbol SA1, and in FIG. 4B, a search area for determining whether the determination-target measurement data point TD2 is the effective data point is represented by a reference symbol SA2.

The search area is defined by a measurement-value range and a time range. The measurement-value range has a predetermined width including a measurement value of the determination-target measurement data point, and the time range has a predetermined width including a measuring time of the determination-target measurement data point. The predetermined width of the measurement-value range corresponds to a difference between an upper limit value and a lower limit value of the measurement-value range. The upper limit value and the lower limit value of the measurement-value range can be defined based on the measurement value of the determination-target measurement data point. In this embodiment, the upper limit value and the lower limit value of the measurement-value range are defined such that the measurement value of the determination-target measurement data point is a median value of the measurement-value range. However, the upper limit value and the lower limit value of the measurement-value range are not limited to this embodiment.

The predetermined width (i.e., a time length) of the time range corresponds to a time required to measure a predetermined number of measurement data points. Therefore, the predetermined width (i.e., the time length) of the time range is defined based on the predetermined number of measurement data points and time intervals when the sensor 30 measures the multiple measurement points MP. In this embodiment, the determination-target measurement data point is the latest measurement data point within the search area, but the time range that defines the search area is not limited to this embodiment.

A size of the search area is constant for all determination-target measurement data points, while the search area moves with the determination-target measurement data point. Specifically, the width of the measurement-value range (the difference between the upper and lower limits) that defines the search area is constant, and the width of the time range (the time length) that defines the search area is also constant, while the upper limit value and the lower limit value of the measurement-value range and the upper limit value and the lower limit value of the time range vary with the determination-target measurement data point.

As shown in FIG. 4A, the search area SA1 corresponding to the determination-target measurement data point TD1 is defined by the measurement-value range having the predetermined width including the measurement value of the determination-target measurement data point TD1 and the time range having the predetermined width including the measuring time of the determination-target measurement data point TD1. Similarly, as shown in FIG. 4B, the search area SA2 corresponding to the determination-target measurement data point TD2 is defined by the measurement-value range having the predetermined width including the measurement value of the determination-target measurement data point TD2 and the time range having the predetermined width including the measuring time of the determination-target measurement data point TD2.

The processing system 40 counts the number of measurement data points within the search area corresponding to the determination-target measurement data point. When the number of measurement data points within the search area is equal to or more than the threshold value, the processing system 40 determines that the determination-target measurement data point is the effective data point. In this embodiment, the number of measurement data points in the search area SA1 corresponding to the determination-target measurement data point TD1 shown in FIG. 4A is less than the threshold value. On the other hand, the number of measurement data points in the search area SA2 corresponding to the determination-target measurement data point TD2 shown in FIG. 4B is equal to or more than the threshold value. Therefore, the processing system 40 determines that the determination-target measurement data point TD1 shown in FIG. 4A is not the effective data point, and determines that the determination-target measurement data point TD2 shown in FIG. 4B is the effective data point.

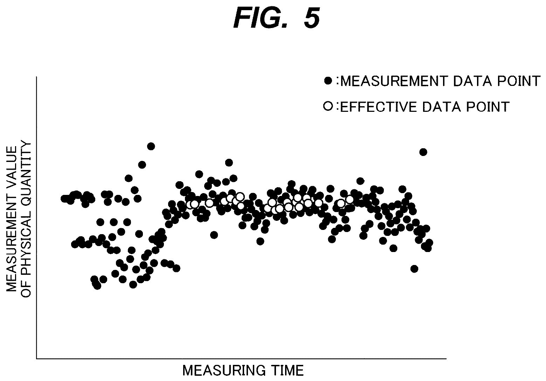

In this manner, each time the polishing table 3 makes one revolution, the processing system 40 determines whether each of the multiple measurement data points at the multiple measurement points MP measured during one revolution of the polishing table 3 is the effective data point. FIG. 5 is a diagram showing effective data points determined by the processing system 40. Measurement data points indicated by white dots in FIG. 5 are measurement data points that have been determined to be the effective data points by the processing system 40. The effective data points include the measurement values of the physical quantity of the substrate W at the measurement points MP located on the substrate W. The size of the search area (i.e., the width of the measurement-value range and the width of the time range) and the threshold value for determining the effective data point are predefined based on experimental results, etc.

In this embodiment, the determination-target measurement data point is the latest measurement data point within the search area. Therefore, the measurement data points in the search area are composed of measurement data points measured earlier than the determination-target measurement data point. The processing system 40 can sequentially determine whether the latest measurement data point measured by the sensor 30 as the determination-target measurement data point is the effective data point. Therefore, the effective data point can be determined in real time during polishing of the substrate W.

The processing system 40 is configured to determine a representative measurement value of the physical quantity of the substrate W based on the measurement values of the measurement data points that have been determined to be the effective data points each time the polishing table 3 makes one revolution. In this embodiment, the processing system 40 is configured to determine the representative measurement value by calculating an average value of the multiple effective data points. In one embodiment, the processing system 40 may be configured to determine the representative measurement value by calculating another representative value, such as a median value of the multiple effective data points.

According to this embodiment, the processing system 40 determines whether each of the multiple measurement data points is the effective data point. These multiple measurement data points are indicative of the measurement values of the physical quantity and the measuring times at the multiple measurement points MP measured by the sensor 30. The processing system 40 then determines the representative measurement value of the physical quantity based on the measurement value of the measurement data point that has been determined to be the effective data point each time the polishing table 3 makes one revolution. As a result, the physical quantity of the substrate W being polished can be accurately measured.

The processing system 40 monitors the physical quantity of the substrate W based on the representative measurement value determined each time the polishing table 3 makes one revolution. In this embodiment, the processing system 40 is configured to terminate polishing of the substrate W when the representative measurement value reaches a target value. In one embodiment, the sensor 30 is a film-thickness sensor configured to measure a film thickness as the physical quantity, and the processing system 40 may terminate polishing of the substrate W when the representative measurement value of the film thickness reaches a target value.

The processing system 40 operates according to instructions contained in the programs electrically stored in the memory 40a. Specifically, the processing system 40 performs: during polishing of the substrate W, determining whether each of the multiple measurement data points is the effective data point while the polishing table 3 makes one revolution, the multiple measurement data points being indicative of the measurement values of the physical quantity and the measuring times at the multiple measurement points MP measured by the sensor 30 installed in the polishing table 3 configured to support the polishing pad 1; and determining the representative measurement value of the physical quantity based on the measurement value(s) of the measurement data point(s) that has been determined to be the effective data point each time the polishing table 3 makes one revolution. The processing system 40 determines whether each of the multiple measurement data points is the effective data point by counting the number of measurement data points within the search area and determining that the determination-target measurement data point is the effective data point when the number of measurement data points within the search area is equal to or more than a threshold value. The search area is defined by the measurement-value range having the predetermined width including the measurement value of the determination-target measurement data point, and the time range having the predetermined width including the measuring time of the determination-target measurement data point.

When the effective data point includes multiple effective data points, the processing system 40 performs calculating an average value of the multiple effective data points to determine the representative measurement value of the physical quantity.

Furthermore, the processing system 40 terminates polishing of the substrate W when the representative measurement value of the physical quantity reaches a target value.

The programs for causing the processing system 40 to perform these steps are stored in a non-transitory tangible computer-readable storage medium, and are provided to the processing system 40 via the storage medium. Alternatively, the programs may be input into the processing system 40 via a communication network, such as the Internet or a local area network.

The above-described embodiments can also be applied to a case where the polishing head 5 and the substrate W are fixed without being oscillated during polishing of the substrate W.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a polishing method and a polishing apparatus for polishing a substrate, such as a wafer or a panel, and a computer-readable storage medium storing a program for determining physical quantity of the substrate being polished.

### Reference Signs List

- 1: polishing pad (polishing tool)
- 1a: polishing surface
- 3: polishing table
- 3a: table shaft
- 5: polishing head
- 6: table motor
- 10: polishing-liquid supply nozzle
- 14: support shaft
- 16: polishing-head arm
- 18: polishing-head shaft
- 20: polishing-head rotating mechanism
- 25: polishing-head oscillating mechanism
- 30: sensor
- 35: trigger sensor
- 35a: dog
- 35b: proximity sensor
- 40: processing system
- 40a: memory
- 40b: arithmetic device
- W: substrate
- MP: measurement point

## Claims

1. A polishing method comprising:
rotating a polishing table supporting a polishing tool having a polishing surface;
pressing a substrate against the polishing surface by a polishing head to polish the substrate;
during polishing of the substrate, measuring physical quantity at multiple measurement points by a sensor installed in the polishing table;
determining whether each of multiple measurement data points is an effective data point, the multiple measurement data points being indicative of measurement values of the physical quantity and measuring times at the multiple measurement points measured during one revolution of the polishing table; and
determining a representative measurement value of the physical quantity based on a measurement value of a measurement data point that has been determined to be the effective data point each time the polishing table makes one revolution,
wherein determining whether each of the multiple measurement data points is the effective data point comprises counting the number of measurement data points within a search area and determining that a determination-target measurement data point is the effective data point when the number of measurement data points within the search area is equal to or more than a threshold value, and
the search area is defined by a measurement-value range and a time range, the measurement-value range has a predetermined width including a measurement value of the determination-target measurement data point, and the time range has a predetermined width including a measuring time of the determination-target measurement data point.

2. The polishing method according to claim 1, wherein the determination-target measurement data point is the latest measurement data point among the measurement data points within the search area.

3. The polishing method according to claim 1, wherein
the effective data point comprises multiple effective data points, and
determining the representative measurement value comprises calculating an average value of the multiple effective data points.

4. The polishing method according to claim 1, further comprising:
terminating polishing of the substrate when the representative measurement value reaches a target value.

5. The polishing method according to claim 1, wherein polishing the substrate comprises pressing the substrate against the polishing surface by the polishing head to polish the substrate while the polishing head is oscillated by a polishing-head oscillating mechanism.

6. The polishing method according to claim 1, wherein the substrate comprises a quadrilateral substrate.

7. The polishing method according to claim 1, wherein the physical quantity comprises any one of film thickness, temperature, sound, and vibration.

8. A polishing apparatus comprising:
a polishing table configured to support a polishing tool having a polishing surface;
a table motor configured to rotate the polishing table;
a polishing head configured to press the substrate against the polishing surface;
a sensor configured to measure physical quantity; and
a processing system configured to determine whether each of multiple measurement data points is an effective data point during polishing of the substrate and determine a representative measurement value of the physical quantity based on a measurement value of a measurement data point that has been determined to be the effective data point each time the polishing table makes one revolution, the multiple measurement data points being indicative of measurement values of the physical quantity and measuring times at multiple measurement points measured during one revolution of the polishing table,
wherein the processing system is configured to count the number of measurement data points within a search area and is configured to determine that a determination-target measurement data point is the effective data point when the number of measurement data points within the search area is equal to or more than a threshold value, and
the search area is defined by a measurement-value range and a time range, the measurement-value range has a predetermined width including a measurement value of the determination-target measurement data point, and the time range has a predetermined width including a measuring time of the determination-target measurement data point.

9. The polishing apparatus according to claim 8, wherein the determination-target measurement data point is the latest measurement data point among the measurement data points within the search area.

10. The polishing apparatus according to claim 8, wherein
the effective data point comprises multiple effective data points, and
the processing system is configured to calculate an average value of the multiple effective data points to determine the representative measurement value.

11. The polishing apparatus according to claim 8, wherein the processing system is configured to terminate polishing of the substrate when the representative measurement value reaches a target value.

12. The polishing apparatus according to claim 8, further comprising:
a polishing-head oscillating mechanism configured to oscillate the polishing head.

13. The polishing apparatus according to claim 8, wherein the substrate comprises a quadrilateral substrate.

14. The polishing apparatus according to claim 8, wherein the sensor comprises any one of a film-thickness sensor, a temperature sensor, an acoustic sensor, and a vibration sensor.

15. A computer-readable storage medium storing a program for causing a computer to perform:
during polishing of a substrate, determining whether each of multiple measurement data points is an effective data point, the multiple measurement data points being indicative of measurement values of physical quantity and measuring times at the multiple measurement points measured by a sensor during one revolution of a polishing table, the sensor being installed in the polishing table supporting a polishing tool having a polishing tool; and
determining a representative measurement value of the physical quantity based on a measurement data point that has been determined to be the effective data point each time the polishing table makes one revolution,
wherein determining whether each of the multiple measurement data points is the effective data point is performed by counting the number of measurement data points within a search area and determining that a determination-target measurement data point is the effective data point when the number of measurement data points within the search area is equal to or more than a threshold value, and
the search area is defined by a measurement-value range and a time range, the measurement-value range has a predetermined width including a measurement value of the determination-target measurement data point, and the time range has a predetermined width including a measuring time of the determination-target measurement data point.

16. The computer-readable storage medium according to claim 15, wherein
the effective data point comprises multiple effective data points, and
determining the representative measurement value comprises calculating an average value of the multiple effective data points.

17. The computer-readable storage medium according to claim 15, wherein the program is configured to cause the computer to further perform terminating polishing of the substrate when the representative measurement value reaches a target value.
